(19) Europäisches Patentamt
European Patent Office
Office européen des brevets

(11) **EP 4 258 836 A1**

(12) **EUROPEAN PATENT APPLICATION**
published in accordance with Art. 153(4) EPC

(43) Date of publication:
**11.10.2023 Bulletin 2023/41**

(21) Application number: **21900119.5**

(22) Date of filing: **03.12.2021**

(51) International Patent Classification (IPC):
*H05K 9/00* [(2006.01)]   *H05K 7/14* [(2006.01)]
*H05K 7/10* [(2006.01)]   *H02M 1/00* [(2006.01)]
*H02M 1/44* [(2007.01)]

(52) Cooperative Patent Classification (CPC):
**H02M 1/44; H05K 7/10; H05K 7/14; H05K 9/00;**
H02M 1/00

(86) International application number:
**PCT/CN2021/135530**

(87) International publication number:
**WO 2022/117097 (09.06.2022 Gazette 2022/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **04.12.2020   CN 202011411658
04.12.2020   CN 202022882444 U**

(71) Applicant: **Shanghai Valeo Automotive
Electrical Systems Co., Ltd.
Shanghai 201201 (CN)**

(72) Inventors:
• **WU, Zhiwei**
  **Shanghai 201201 (CN)**
• **HU, Jie**
  **Shanghai 201201 (CN)**
• **LI, Jianping**
  **Shanghai 201201 (CN)**
• **YI, Zhenhua**
  **Shanghai 201201 (CN)**
• **LIANG, Cuiping**
  **Shanghai 201201 (CN)**

(74) Representative: **Valeo Powertrain Systems
Service Propriété Intellectuelle
Immeuble le Delta
14, avenue des Béguines
95892 Cergy Pontoise (FR)**

(54) **POWER CONVERTER**

(57)   The present invention relates to the technical field of power converters, and disclosed is a power converter. The power converter comprises a printed circuit board, a connection member, and a housing, and the printed circuit board is provided with a power device and a control device; one end of the connection member is connected to an external wire harness, and the other end is connected to the printed circuit board; a blocking wall is arranged within the housing, the printed circuit board is installed within the housing, the printed circuit board abuts against the blocking wall, and the blocking wall is surroundingly arranged at an outer side of the connection member, so as to isolate the power device and the control device from the connection member. The blocking wall is surroundingly arranged at an outer side of the connection member and isolates the power device and the control device from the connection member, radiation interference is spatially completely obstructed from being inwardly or outwardly transmitted by means of a connection portion of the connection member, and same has a good shielding effect, thereby improving electromagnetic compatibility radiation disturbance performance.

Fig. 2

## Description

### TECHNICAL FIELD

The present disclosure relates to the technical field of power converters and, more particularly, to a power converter.

### BACKGROUND

A power converter can convert DC voltages to lower or higher DC voltages. Electronic products must meet the requirements of electromagnetic compatibility standards. Owing to the high power and high operating frequency of an automotive power converter, radiation interference generated by the connection portion between the connection member and the printed circuit board during operation is inwardly or outwardly transmitted, and consequently, the electromagnetic compatibility performance of the power converter easily exceeds the standard requirements but cannot meet the use requirements.

Based on this, there is an urgent need for a power converter to solve the above-mentioned problem.

### SUMMARY

Based on the above, the purpose of the present disclosure is to provide a power converter, and the present disclosure improves electromagnetic compatibility radiation disturbance performance.

To achieve the above-mentioned purpose, the present disclosure uses the following technical solution:

A power converter, comprising:

a printed circuit board, the printed circuit board being provided with a power device and a control device;
a connection member, one end of the connection member being connected to an external wire harness of the power converter, and the other end being connected to the printed circuit board;
a housing, a blocking wall being arranged within the housing, the printed circuit board being installed within the housing, the printed circuit board abutting against the blocking wall, and the blocking wall surrounding an outer side of the connection member to isolate the power device and the control device from the connection member.

In one embodiment of the power converter, a screw hole is disposed in the blocking wall, a fixing hole is disposed in the printed circuit board, and a screw passes through the fixing hole and is connected to the screw hole by a thread to fix the printed circuit board on top of the blocking wall; or
a welding pin is disposed on a top surface of the blocking wall, a welding hole is disposed in the printed circuit board, and the welding pin passes through the welding hole and is connected to the welding hole by welding.

In one embodiment of the power converter, the material of both the blocking wall and the housing is a metal, and the blocking wall and the housing are integrally formed.

In one embodiment of the power converter, the connection member comprises:

a first contact, the first contact being provided with a first power terminal, a first end of the first power terminal being connected to the external wire harness; and
a second contact, the second contact being provided with a second power terminal, a second end of the first power terminal being fixedly and electrically connected to the second power terminal, and the first power terminal being electrically connected to the printed circuit board by means of the second power terminal;
welded connection is used between the first power terminal and the second power terminal; or
screw connection is used between the first power terminal and the second power terminal.

In one embodiment of the power converter, a differential mode inductor terminal is disposed on the second power terminal, a differential mode inductor is disposed on the printed circuit board, and the differential mode inductor terminal is electrically connected to the differential mode inductor.

In one embodiment of the power converter, the differential mode inductor terminal comprises a plurality of differential mode inductor sub-terminals, the plurality of differential mode inductor sub-terminals being arranged within a circle with a diameter of not more than 17 mm, and the distance between any two of the plurality of differential mode inductor sub-terminals is not less than 3 mm.

In one embodiment of the power converter, the second contact further comprises a magnetic ring, wherein mounting positions are disposed on the second contact, the magnetic ring is installed within the mounting positions, and the magnetic ring is arranged around an outer side of the differential mode inductor terminal.

In one embodiment of the power converter, the mounting positions are mounting ribs, and the magnetic ring is bonded to the mounting ribs by glue dispensing; or

the magnetic ring is snapped into the mounting ribs; or

the number of mounting ribs are at least two, the magnetic ring being installed between the mounting ribs, threaded holes being disposed in the mounting ribs, and bolts being connected to the threaded holes by threads such that the end faces of the bolts abut against the magnetic ring.

In one embodiment of the power converter, a common mode capacitor terminal is disposed on the second power terminal, a common mode capacitor is disposed on the printed circuit board, and the common mode capacitor terminal is electrically connected to the common mode capacitor.

In one embodiment of the power converter, the first contact is further provided with a signal terminal, one end of the signal terminal is connected to an external signal wire harness, and the other end is connected to the printed circuit board.

The present disclosure has the following beneficial effects:

The present disclosure discloses a power converter. The power converter comprises a printed circuit board, a connection member, and a housing, and the printed circuit board is provided with a power device and a control device; one end of the connection member is connected to an external wire harness, and the other end is connected to the printed circuit board; a blocking wall is arranged within the housing, the printed circuit board is installed within the housing, and the printed circuit board abuts against the blocking wall. After the connection member is connected to the printed circuit board, radiation interference is generated during operation. The blocking wall surrounds an outer side of the connection member and isolates the power device and the control device from the connection member, and radiation interference is spatially completely obstructed from being inwardly or outwardly transmitted by means of a connection portion of the connection member to deliver a good shielding effect, thereby improving electromagnetic compatibility radiation disturbance performance.

**BRIEF DESCRIPTION OF THE DRAWINGS**

To clearly describe the technical solution in the embodiments of the present disclosure, drawings to be used in the description of the embodiments of the present disclosure will be introduced below. Obviously, the drawings in the following description are only some embodiments of the present disclosure. Those of ordinary skill in the art can obtain other drawings according to the contents of the embodiments of the present disclosure and these drawings without creative work.

Fig. 1 is a structural schematic diagram of a first perspective of a power converter provided according to an embodiment of the present disclosure.

Fig. 2 is a structural schematic diagram of a connection member and housing provided according to an embodiment of the present disclosure.

Fig. 3 is a structural schematic diagram of a connection member provided according to an embodiment of the present disclosure.

Fig. 4 is an exploded view of the structure of a power converter provided according to an embodiment of the present disclosure.

Fig. 5 is a structural schematic diagram of a second perspective of a power converter provided according to an embodiment of the present disclosure.

Fig. 6 is a structural schematic diagram of a first perspective of a housing provided according to an embodiment of the present disclosure.

Fig. 7 is a structural schematic diagram of a second perspective of a housing provided according to an embodiment of the present disclosure.

Fig. 8 is a partial exploded view of the structure of a power converter provided according to an embodiment of the present disclosure.

The reference numerals used in the figures are as follows:

1. Printed circuit board; 11. Busbar;

2. Connection member; 21. First contact; 211. First power terminal; 2111. Connection stud; 212. Signal terminal; 213. First body; 22. Second contact; 221. Second power terminal; 2211. Differential mode inductor terminal; 2212.Common mode capacitor terminal; 222. Second body; 2221. Semicircular rib; 23. magnetic ring;

3. Housing assembly; 31. Upper cover plate; 32. Housing; 321. Blocking wall; 3211. Screw hole; 322. Communicating groove; 3221. Flow guide rib; 323. First water pipe; 324. Second water pipe; 325. Mounting cavity; 3251. First heat dissipation part; 3252. Second heat dissipation part; 3253. Third heat dissipation part; 33. Lower cover plate; 34. Sealant layer.

## DETAILED DESCRIPTION

The present disclosure is further described below in detail by referring to the accompanying drawings and embodiments. It should be understood that particular embodiments described here are used only to explain the present disclosure rather than restrict it. It is also important to note that for the convenience of description, the accompanying drawings show only the part related to the present disclosure instead of the entire structure.

In the description of the present disclosure, unless otherwise expressly specified and defined, terms such as "coupled", "connected", and "fixed" should be understood in a broad sense, for example, fixedly connected, detachably connected or integrally connected; or mechanically connected or electrically connected; or coupled directly or through an intermediate; or two elements communicated internally or interacting. Those of ordinary skill in the art may understand the specific meanings of the above-mentioned terms in the present disclosure as the case may be.

In the present disclosure, unless otherwise specified and defined, a first feature being "above" or "below" a second feature includes the conditions that the first feature and the second feature are in direct contact, or the first feature and the second feature are contacted through another feature between them instead of direct contact. In addition, the first feature being "above", "over" and "on" the second feature involves the conditions that the first feature is directly above and obliquely above the second feature, or merely indicates that the first feature is higher than the second feature in height. The first feature being "below", "under" and "beneath" the second feature includes the conditions that the first feature is directly below and obliquely below the second feature, or merely indicates that the first feature is lower than the second feature in height.

The directions or location relations indicated by "upper", "lower", "left", "right", and other terms in the description of the present disclosure are based on directions or location relations shown in the figures, only for the convenience of the description and simplification of operations, not for any indication or implication that any indicated device or element must have a specific direction and be constructed and operated in a specific direction, and thus should not be interpreted as any limitation on the present disclosure. In addition, terms "first" and "second" are only used for distinguishing in description and have no special meaning.

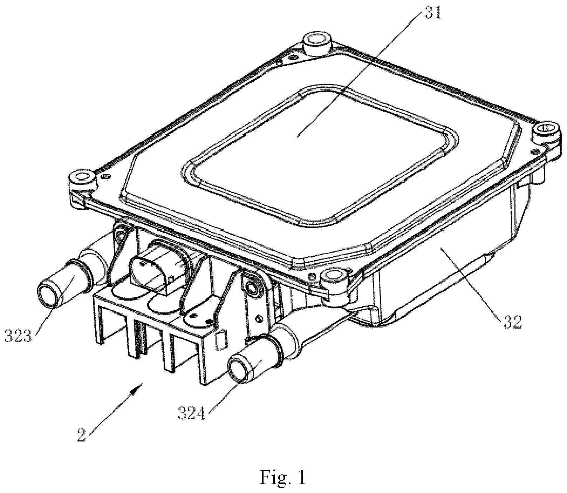

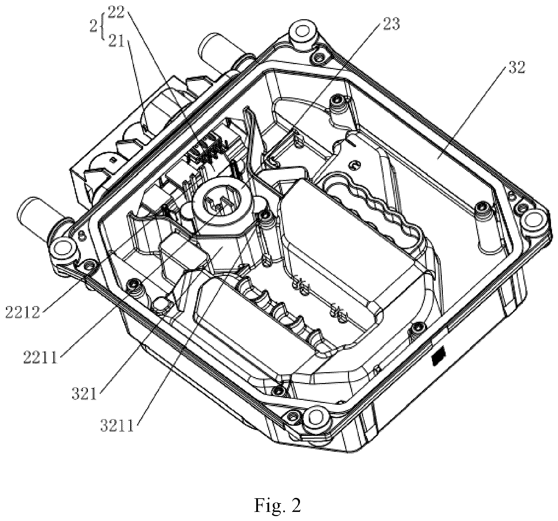

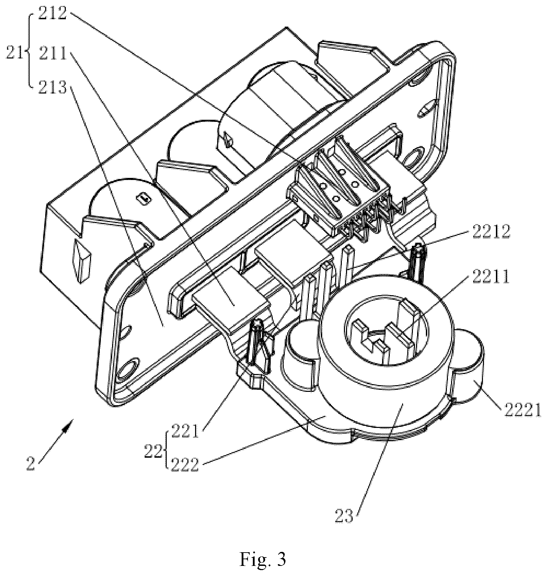

This embodiment provides a power converter, comprising a housing assembly 3, a printed circuit board 1, and a connection member 2, as shown in Figs. 1 through 8. Specifically, the housing assembly 3 comprises a housing 32 and an upper cover plate 31 and lower cover plate 33 disposed on the housing 32. Amounting cavity 325 and a communicating groove 322 are provided on the housing 32, the upper cover plate 31 and the mounting cavity 325 form a receiving space, the printed circuit board 1 is disposed in the receiving space, the lower cover plate 33 and the communicating groove 322 form a waterway channel, and coolant flows through the waterway channel to cool the printed circuit board 1 in the receiving space; the connection member 2 is detachably installed to the housing 32, one end of the connection member 2 is connected to an external wire harness of the power converter, and the other end is connected to the printed circuit board 1.

Specifically, as shown in Figs. 1 through 4, the printed circuit board 1 is provided with a power device and a control device, a blocking wall 321 is arranged within the housing 32, the printed circuit board 1 is installed within the housing 32, and the printed circuit board 1 abuts against the blocking wall 321. After the connection member 2 is connected to the printed circuit board 1, radiation interference is generated during operation. The blocking wall 321 surrounds an outer side of the connection member 2, and the blocking wall 321 is higher than a connecting port of the connection member 2 in height and isolates the power device and the control device from the connection member 2 so that radiation interference is spatially completely obstructed from being inwardly or outwardly transmitted by means of a connection portion of the connection member 2 so that a good shielding effect is achieved, thereby improving electromagnetic compatibility radiation disturbance performance.

Preferably, a screw hole 3211 is disposed in the blocking wall 321, a fixing hole is disposed in the printed circuit board 1, and a screw passes through the fixing hole and is connected to the screw hole 3211 by threads, so as to fix the printed circuit board 1 to the top of the blocking wall 321. Moreover, common mode noise on the printed circuit board 1 can be conducted to the housing 32 through the metal screw and the blocking wall 321, thereby eliminating common mode noise better. In another embodiment, a welding pin is disposed on a top surface of the blocking wall 321, and a welding hole is disposed in the printed circuit board 1, wherein the welding pin passes through the welding hole and is connected to the welding hole by welding.

Further preferably, the material of both the blocking wall 321 and the housing 32 is a metal, and the blocking wall 321 and the housing 32 are integrally formed by a casting process. Casting aluminium has a good electromagnetic interference isolation effect, and there is no gap between the blocking wall 321 and the housing 32, which improves the emission of common mode noise. Of course, the blocking wall 321 and the housing 32 can also be separate structures in other embodiments. Preferably, the material of the blocking wall 321 and the housing 32 is cast aluminium in this embodiment, thereby saving processing costs and meeting performance requirements. In other embodiments, the material may be other metals such as stainless steel, ordinary cold-rolled sheet, aluminium sheet, hot-dip galvanized steel sheet, aluminium alloy sheet, and sandwich color steel sheet.

Optionally, the connection member 2 comprises a first contact 21 and a second contact 22, wherein the first contact 21 is provided with a first power terminal 211, a first end of the first power terminal 211 is connected to an external wire harness, the first end of the first power terminal 211 is provided with a connection stud 2111, and the first end of the first power terminal 211 is connected to the external wire harness of the power converter by means of the connection stud 2111. Preferably, the first contact 21 is further provided with a signal terminal 212 in this embodiment, one end of the signal terminal 212 is connected to an external signal wire harness, and the other end is connected to the printed circuit board 1 to transfer signals. A second contact 22 is arranged below the printed circuit board 1, the second contact 22 is provided with a second power terminal 221, a second end of the first power terminal 211 is fixedly and electrically connected to the second power terminal 221, and the first power terminal 211 is electrically connected to the printed circuit board 1 by means of the second power terminal 221 to connect circuits. In this embodiment, the connection member 2 is a separate structure, the sizes of the terminals in the connection member 2 are reduced, the mold structure is simplified, the size of the internal terminal of each contact of the first contact 21 and the second contact 22 is reduced compared with the connection members of the prior art, and the product design is simple; in addition, the two independent contacts are small in size, and the plastic wrapping area on the copper bars is small so that leakage due to cracking can be prevented.

Preferably, welded connection is used between the first power terminal 211 and the second power terminal 221 in this embodiment, wherein the welding method is brazed connection. In other embodiments, screw connection is used between the first power terminal 211 and the second power terminal 221. The above-mentioned methods achieve both fixed connection and electrical connection between the two terminals.

In this embodiment, the first contact 21 comprises a first body 213, the first power terminal 211 and the signal terminal 212 are arranged in the first body 213, the first body 213 is plastic, and the first body 213, the first power terminal 211, and the signal terminal 212 are integrally formed by an injection mold. The second contact 22 comprises a second body 222, the second power terminal 221 is arranged in the second body 222, the second body 222 is plastic, and the second body 222 and the second power terminal 221 are integrally formed by an injection mold.

In the prior art, the structures of the terminals in the connection member are complex. Owing to problems of associated with the injection mold making process, terminals cannot be easily made into a compact structure and cannot be connected to a differential mode inductor to reduce electromagnetic interference with external devices from the connection member. In this embodiment, the structure of the terminal in the second contact 22 is simple, so a differential mode inductor terminal 2211 can be disposed on the second power terminal 221 and a differential mode inductor can be disposed on the printed circuit board 1. The differential mode inductor terminal 2211 is electrically connected to the differential mode inductor on the printed circuit board 1 to reduce electromagnetic interference from the connection member 2 to external devices.

Optionally, the connection member 2 further comprises a magnetic ring 23 and the magnetic ring 23 is bonded to the second contact 22.

Specifically, mounting positions are disposed on the second body 222 of the second contact 22, the magnetic ring 23 is installed within the mounting positions, and the magnetic ring 23 is arranged around an outer side of the differential mode inductor terminal 2211. The arrangement of the magnetic ring 23 can inhibit the inward or outward transmission of electromagnetic radiation, improving electromagnetic compatibility. Further preferably, the mounting positions are mounting ribs. It is important to note that the magnetic ring 23 is an EMC magnetic ring in this embodiment.

Preferably, the mounting ribs are at least two oppositely arranged semicircular ribs 2221 and the magnetic ring 23 is bonded between the at least two semicircular ribs 2221 by glue dispensing in this embodiment. In other embodiments, the magnetic ring 23 is snapped into the mounting ribs. Alternatively, the magnetic ring 23 is installed between the mounting ribs, threaded holes are disposed in the mounting ribs, and bolts are connected to the threaded holes by threads so that end faces of the bolts abut against the magnetic ring 23.

In this embodiment, the differential mode inductor terminal 2211 comprises a plurality of differential mode inductor sub-terminals, and the plurality of differential mode inductor sub-terminals are arranged within a circle with a diameter of not more than 17 mm; the distance between any two of the plurality of differential mode inductor sub-terminals is not less than 3 mm, which meets the hazardous thermal event (HTE) requirements and prevents internal short circuiting between the differential mode inductor sub-terminals. In this embodiment, three differential mode inductor sub-terminals including a 12 V differential mode inductor terminal, a 48 V differential mode inductor terminal, and an earthing differential mode inductor terminal are provided, the distance between the 48 V differential mode inductor terminal and the earthing differential mode inductor terminal is 5 mm, and the distance between the earthing differential mode inductor terminal and the 12 V differential mode inductor terminal is 3.3 mm. In this embodiment, the inner diameter of the magnetic ring 23 is 18.75 mm and the outer diameter of the magnetic ring 23 is 38 mm. Further preferably, an insulating plating is disposed on an outer surface of the magnetic ring 23, and the insulating plating is high polymer material (gum, rubber, or animal glue), epoxy resin, etc., to avoid short circuiting after the rupture of the magnetic ring 23.

Furthermore, a common mode capacitor terminal 2212 is disposed on the second power terminal 221, a common mode capacitor is disposed on the printed circuit board 1, and the common mode capacitor terminal 2212 is electrically connected to the common mode capacitor on the printed circuit board 1 so that the connecting circuit is the shortest.

It is important to particularly note that, in this embodiment, the first power terminal 211 and the second power terminal 221 include three corresponding terminals each, and the three terminals respectively are a 12 V terminal, an earthing terminal, and a 48 V terminal. Plating treatment is performed on the terminal surface to meet the welding requirements and the plating is one of or any combination of at least two of tin, zinc, silver, and nickel. A connection stud 2111 for connecting an external wire harness is disposed at the first end of each first power terminal 211. A differential mode inductor terminal 2211 and a common mode capacitor terminal 2212 are disposed on each second power terminal 221. The cross-sectional area of the second power terminal 221 is designed to be 21 mm$^2$ to satisfy the peak current of 210 A.

Preferably, the housing 32 and the lower cover plate 33 form a waterway channel for cooling, the housing 32 and the upper cover plate 31 form a receiving space for providing a fixing point and mounting space for the printed circuit board 1, and the housing assembly 3 achieves integrated arrangement of the waterway channel, the printed circuit board 1, and the connection member 2, improving the structural integration level, decreasing the structural volume, simplifying the structure, and reducing the cost. To further improve the reliability of the power converter, the details are as follows: Referring to the prior art, the lower cover plate 33 may be installed on the opening of the communicating groove 322 by clamping, screw fixing, and other detachable connection methods, and a sealing ring or metal gasket is disposed between the lower cover plate 33 and the communicating groove 322 to achieve sealing between the lower cover plate 33 and the communicating groove 322. However, such connection methods involve a complex structure and operational inconvenience. To improve the cooling performance of the power converter and reduce the leakage risk of the cooling water, optionally, the lower cover plate 33 is connected to the housing 32 by welding. This connection is reliable, reduces the leakage risk of the waterway channel, and improves the reliability of the cooling device. In addition, the welded connection process between the lower cover plate 33 and the housing 32 is simple and reliable. Specifically, the lower cover plate 33 and the housing 32 may be made of the same or different materials. Preferably, the lower cover plate 33 is bonded or welded to the opening of the communicating groove 322 to achieve a sealed fit between the lower cover plate 33 and the communicating groove 322 in this embodiment. Specifically, the lower cover plate 33 and the housing 32 are welded by the friction stir welding method to facilitate connection between the lower cover plate 33 and housing 32 of the same or different materials. Optionally, both the lower cover plate 33 and the housing 32 are made of a metal.

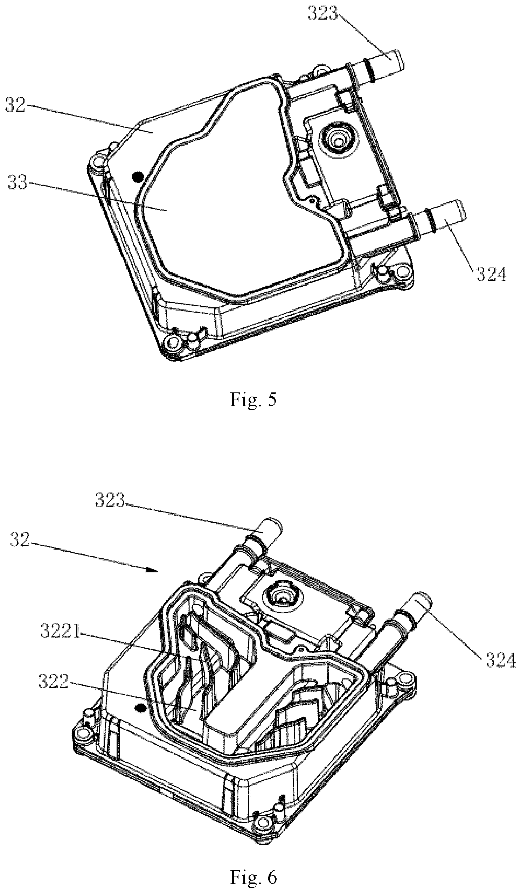

This is to further simplify the structure, improve the cooling performance of the power converter, and reduce the leakage risk of the cooling water. Specifically, as shown in Figs. 5 and 6, a first water pipe 323 and a second water pipe 324 are further disposed on the housing 32, wherein the first water pipe 323 and the second water pipe 324 are respectively connected to the communicating groove 322, one of the first water pipe 323 and the second water pipe 324 is used for the inflow of water into the waterway channel, and the other is used for the outflow of water from the waterway channel to achieve the circulation of coolant in the waterway channel. Specifically, a water pump is arranged outside the power converter, water in the water pump flows into the communicating groove 322 through the first water pipe 323 and is discharged from the second water pipe 324, and a cooling waterway is formed in the communicating groove 322 to improve the heat dissipation effect. Specifically, both the first water pipe 323 and second water pipe 324 are integrally formed together with the housing 32, simplifying the structure, reducing the assembly process steps and the leakage risk at the connection, and further improving the reliability of the cooling device.

Because the water pipes occupy a large space, when the first water pipe 323 and the second water pipe 324 are provided on both sides of the housing 32, both sides will occupy a large space, causing low space utilization. Optionally, the first water pipe 323 and the second water pipe 324 are located on the same side of the housing 32, saving the space on the other side of the housing 32 and increasing the space utilization; the first water pipe 323 and the second water pipe 324 are symmetrically arranged, improving the appearance of the cooling device.

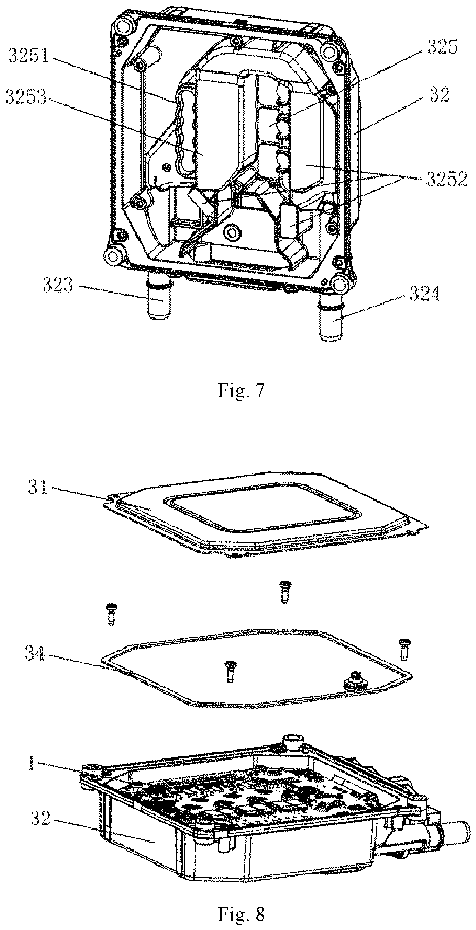

In the prior design, flow dead zones may easily occur when coolant flows in the water pipes, causing a bad cooling effect. In this embodiment, to solve the above-mentioned problem, the communicating groove 322 is provided with a flow guide rib 3221 so as to divide the communicating groove 322, the flow guide rib 3221 divides the waterway channel into shunt channels, and coolant circulates in the shunt channels, reducing coolant flow dead zones in the waterway channel and improving the smoothness of coolant circulation and the heat dissipation efficiency, as shown in Figs. 6 and 7.

According to flow formula 1 and Bernoulli's equation 2,

$$Q=Sv=\text{constant} \qquad (1)$$

$$P+ (1/2) \rho v^2 + \rho gh = C \qquad (2)$$

wherein,

Q is the flow rate, S is the cross-sectional area, and v is the water velocity;

P is the pressure at a point in the fluid, v is the fluid velocity at this point, $\rho$ is the fluid density, g is the acceleration of gravity, h is the height at this point, and C is a constant.

According to Bernoulli's equation, a smaller pressure difference in the shunt channels indicates a smaller flow velocity difference and a better cooling effect; according to the flow rate equation, the flow rate is a constant value provided by the vehicle cooling system, so a smaller flow velocity difference indicates a smaller cross-sectional area difference of the shunt channels, and it is thus deduced that the closer the cross-sectional areas of the shunt channels are, the better cooling effect of the cooling device.

Optionally, at least two flow guide ribs 3221 are provided on the communicating groove 322, the cross-sectional area of any shunt channel is S1, and the cross-sectional area of other shunt channels is S2, where $0.8 \leq S1/S2 \leq 1.2$ so that the volumes of the shunt channels are approximately equal, and the pressures of the shunt channels are approximately equal within this range, reducing the pressure loss, decreasing the flow velocity difference in different shunt channels, increasing the heat dissipation efficiency, improving the uniformity of coolant flow velocity in the shunt channels, and lowering the impact on the wall of the shunt channels.

Optionally, the flow guide rib 3221 is a smoothly curved plate or a flat plate, and the specific shape can be set according to the shape of the waterway channel, such that water in the waterway channel flows along the flow guide rib 3221, reducing the resistance of the flow guide rib 3221 to the flow of coolant and improving the circulation effect. Specifically, the flow guide rib 3221 is adapted to the shape of the wall of the communicating groove 322 to avoid the formation of a large included angle between the flow guide rib 3221 and the wall of the communicating groove 322, affecting coolant circulation. Specifically, fluid simulation analysis may be used to arrange a flow guide rib 3221, and specifically, a certain flow rate of coolant is given in the waterway channel, and when a vortex is formed in a position, a flow guide rib 3221 is added in the vortex position; a certain flow rate of coolant is given again, and when a vortex is generated, the number of flow guide ribs 3221 is adjusted and the structure of the flow guide rib 3221 is twisted or disconnected; the above-mentioned process is repeated to eliminate the effect of vortices.

In this embodiment, as shown in Fig. 6, seven flow guide ribs 3221 are disposed in the communicating groove 322, the shunt channels have approximately equal cross-sectional areas and a uniform flow velocity, improving the cooling effect, and all the flow velocities are less than 5 m/s, reducing the impact force; specifically, calculations may be done according to fluid simulation, wherein the pressure difference between the shunt channels is reversely deduced according to the required cooling efficiency to obtain a preset pressure difference, and the cooling requirements can be met by ensuring that the pressure difference is less than the preset pressure difference; the relation between the cross-sectional areas of the shunt channels is deduced according to the pressure difference. Preferably, S 1 = S2, the cross-sectional area difference between the shunt channels reaches the lowest value, and v1 = v2. At this moment, the intensity of pressure at each point in the waterway channel is equal, the flow velocity through the cross-section in the shunt channels is the same, and the cooling efficiency is the highest.

Optionally, one end of the flow guide rib 3221 away from the bottom of the communicating groove 322 abuts against the lower cover plate 33, that is, the flow guide rib 3221 is flush with the lower cover plate 33 in height, improving the coolant shunt effect of the shunt channels. Optionally, the thickness of the flow guide rib 3221 is 2.5 mm-3.5 mm, to avoid reducing the volume of the shunt channels due to excessive thickness of the flow guide rib 3221, and avoid insufficient structural strength due to too small a thickness of the flow guide rib 3221; optionally, the thickness of the flow guide rib 3221 is 3 mm.

Optionally, the flow guide rib 3221 is perpendicular to the bottom of the communicating groove 322 to facilitate processing and molding. In this embodiment, the flow guide rib 3221 and the housing 32 are integrally formed, simplifying the structure, reducing the assembly process steps, and further improving the reliability of structural connection. In other embodiments, the flow guide rib 3221 and the housing 32 are separate structures; specifically, the flow guide rib 3221 can be bonded or welded to the housing 32, and the flow guide rib 3221 can also be detachably connected to the housing 32 by using a fastener.

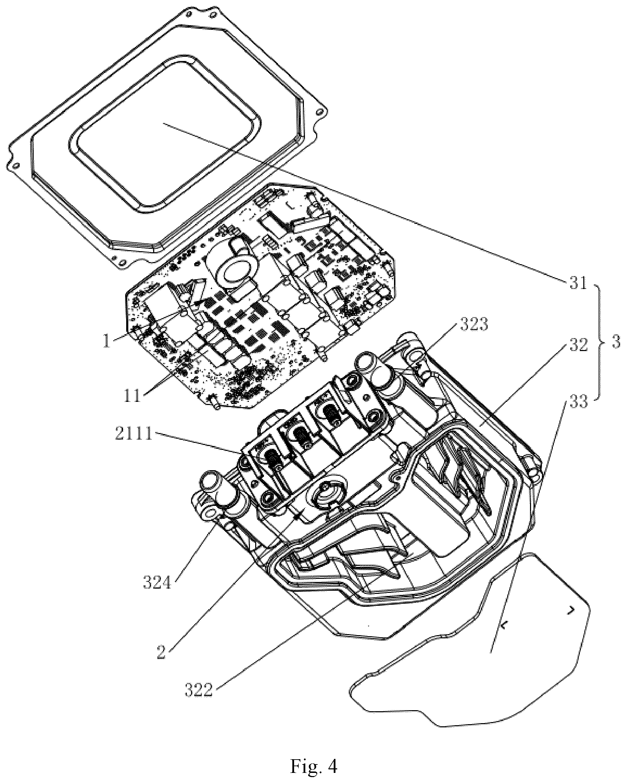

Optionally, as shown in Figs. 1 and 4, the busbar 11 is fixed to the back of the printed circuit board 1, and the housing 32 is on one side of the busbar 11 away from the printed circuit board 1. Because the number of electronic components on the back of the printed circuit board 1 is small, the busbar 11 can be horizontally disposed and the two ends can be welded to the back of the printed circuit board 1, increasing the fixing strength of the busbar 11.

Optionally, the busbar 11 is flat and the busbar 11 is laid flat on the back of the printed circuit board 1; or the busbar 11 is arched and both ends of the busbar 11 are fixed to the back of the printed circuit board 1. Moreover, the busbar 11 is provided with a through hole at the center along the length direction; or the busbar 11 is provided with a cavity with an opening at one end at the center along the length direction, both of which can meet the use requirements.

Preferably, some parts on the back of the printed circuit board 1 are higher than the busbar 11 in height, so the housing 32 is provided with a recessed communicating groove 322 to avoid high parts and to reduce the distance between the housing 32 and the busbar 11. The position of the communicating groove 322 matches the position of the busbar 11. A heat dissipation medium is applied to the bottom wall of the communicating groove 322 to conduct the heat generated by the busbar 11 to the waterway channel and reduce the distance between the housing 32 and the busbar 11.

Furthermore, in this embodiment, the length direction of the busbar 11 is axial, and the radial effective cross-sectional area of the busbar 11 along the length direction needs to meet the requirement that the overcurrent per unit area ($mm^2$) should not be more than 10 A. In this embodiment, the maximum carrying current of the busbar 11 in the power converter is 210 A according to the formula: Actual current/Cross-sectional area $\leq$ 10 A/$mm^2$. In this embodiment, the effective cross-sectional area of the busbar 11 is not less than 21 $mm^2$. Further preferably, considering the difficulty in stamping in case of overheight of the busbar 11, there will be inadequate heat dissipation area in case of overwidth of the busbar 11, and difficulty in processing, poor stability of product dimensions, and a likelihood of detachment during vibration in case of overlength of the busbar 11. Therefore, the length, width, and height of the busbar 11 are 25 mm, 7 mm, and 3 mm in this embodiment, respectively.

Preferably, in this embodiment, the outer surface of the busbar 11 is provided with a welding plating, and the busbar 11 is welded to the back of the printed circuit board 1 by using double-sided reflow soldering via the welding plating, which improves the assembly efficiency of the busbar 11 compared with the assembly method of the prior art. In this embodiment, the welding plating is one or any combination of at least two of tin, zinc, silver, and nickel.

Optionally, the printed circuit board 1 is further provided with capacitors, inductors, and other electronic components that are welded to the printed circuit board 1 by using the double-sided reflow soldering process. Specifically, the printed circuit board 1 is fixed to the housing 32 with bolts to stably install the structure. The waterway channel can reduce the heat generated by capacitors, inductors, and other electronic components, improving the service life of the electronic components and thus the service life of the power converter.

To improve the cooling effect, specifically, a first cavity of the mounting cavity 325 for installing an inductor is sunken in the middle of the communicating groove 322 to divide the communicating groove 322 into a first communicating groove and a second communicating groove, the first communicating groove and the second communicating groove communicate, and the first communicating groove and the second communicating groove are arranged on both sides of the first cavity; when the printed circuit board 1 is arranged within the mounting cavity 325, cooling water in the first communicating groove and second communicating groove on both sides of the first cavity cools the inductor in the first cavity at the same time, improving the cooling effect.

When the heat of the printed circuit board 1 is conducted directly through the water pipes, the heat dissipation efficiency is low, for example, dissipating heat from the chip capacitors is limited to applying a heat dissipation adhesive to the bottom, such that the heat of the capacitors may not be conducted out promptly. Therefore, optionally, a heat dissipation part is arranged within the mounting cavity 325, the printed circuit board 1 is disposed on the heat dissipation part, and the printed circuit board 1 conducts the generated heat to the waterway channel via the heat dissipation part, improving heat conduction between the printed circuit board 1 and the waterway channel, facilitating heat exchange through the coolant, and further increasing the heat dissipation efficiency. Optionally, the heat dissipation part matches the shape of the printed circuit board 1, a heat dissipation adhesive coating is provided between the heat dissipation part and the printed circuit board 1, and the heat dissipation adhesive coating improves heat conduction between the printed circuit board 1 and the heat dissipation part, improving the cooling effect. In this embodiment, as shown in Figs. 1 and 4, the busbar 11, capacitors, and other electronic components are provided on the printed circuit board 1, and the heat dissipation part includes at least a first heat dissipation part 3251 and a second heat dissipation part 3252. Specifically, as shown in Fig. 7, the first heat dissipation part 3251 matches the shape of the capacitors. In this embodiment, the capacitors are cylindrical, the first heat dissipation part 3251 is arc-shaped, and the arc-shaped first heat dissipation part 3251 fits the cylindrical capacitors to increase the contact area between the capacitors and the heat dissipation adhesive coating, improving heat conduction between the capacitors and the first heat dissipation part 3251, and improving the heat dissipation effect. Specifically, a heat dissipation adhesive is applied between the first heat dissipation part 3251 and the capacitors to form a heat dissipation adhesive coating, further improving the heat dissipation effect between the capacitors and the first heat dissipation part 3251; similarly, in this embodiment, the busbar 11 is disposed on the second heat dissipation part 3252, the surface where the busbar 11 contacts the second heat dissipation part 3252 has a planar structure, and the second heat dissipation part 3252 also has a planar structure, increasing the area of contact between the busbar 11 and the second heat dissipation part 3252, thus improving heat conduction, and thereby improving the heat dissipation effect. Specifically, a heat dissipation adhesive is applied between the second heat dissipation part 3252 and the busbar 11, further improving the heat dissipation effect between the busbar 11 and the second heat dissipation part 3252. Similarly, in this embodiment, the heat dissipation part further comprises a third heat dissipation part 3253, the printed circuit board 1 is provided with a high-power MOSFET structure in addition to the capacitors and the busbar 11, and the high-power MOSFET corresponds to the third heat dissipation part 3253 and is coated with a heat dissipation adhesive coating, improving the heat dissipation effect.

Optionally, a heat dissipation adhesive coating is provided on the mounting cavity 325; specifically, the heat dissipation adhesive is filled between the printed circuit board 1 and the housing 32, conducts to the housing 32 the heat emitted by electronic components on the printed circuit board 1 during operation, and plays a role of heat dissipation to improve heat transfer from the printed circuit board 1 to the housing 32. After cooling water flows into the waterway channel, cooling water carries away the heat conducted by the heat dissipation adhesive coating to avoid functional failure due to overtemperature of electronic components on the printed circuit board 1, increasing the cooling efficiency of the power converter. Optionally, the housing 32 is a metal housing with good heat dispersion performance.

Similarly, optionally, thermally conductive insulating gaskets are also provided between the heat dissipation part and the printed circuit board 1, increasing heat conduction between the printed circuit board 1 and the heat dissipation part, and improving the cooling effect. Thermally conductive insulating gaskets are directly installed between the first heat dissipation part 3251 and the capacitors, improving the heat dissipation effect between the capacitors and the first heat dissipation part 3251; a thermally conductive insulating gasket is directly installed between the second heat dissipation part 3252 and the busbar 11, improving the heat dissipation effect between the second heat dissipation part 3252 and the busbar 11. A thermally conductive insulating gasket is directly installed between the third heat dissipation part 3253 and the printed circuit board 1 corresponding to the high-power MOSFET, improving the heat dissipation effect between the third heat dissipation part 3253 and the high-power MOSFET. A heat dissipation adhesive or thermally conductive insulating gaskets may be selected according to actual situations and are not limitations.

In this embodiment, the heat dissipation part and the housing 32 are integrally formed, simplifying the structure and further improving the reliability of structural connection. In other embodiments, the heat dissipation part and the housing 32 are separate structures.

Optionally, the upper cover plate 31 is detachably connected to the housing 32 and the upper cover plate 31 is used to protect the printed circuit board 1 in the mounting cavity 325 from impacts of foreign objects and avoid damage to electronic components and short circuiting, thus improving the reliability of the printed circuit board 1. Optionally, the upper cover plate 31 is a stamped cover plate, a mounting hole is provided on the stamped cover plate, a corresponding connecting hole is provided on the housing 32, and the stamped cover plate is detachably connected to the housing 32 by using a fastener passing through the mounting hole and the connecting hole.

Optionally, a sealant coating 34 is provided between the upper cover plate 31 and the housing 32 to avoid the entry of any liquid or solid particles into the product that may destroy the structure of the printed circuit board 1 and cause electrical performance failure of the printed circuit board 1; specifically, the sealant is applied to the edge of the housing 32, and the upper cover plate 31 is then installed on the edge of the housing 32, achieving ease of operation and high sealing reliability.

Optionally, a breather plug is disposed on the housing 32 for protection from dust and water and for effective exchange between internal and external gases to ensure that harmful gases do not affect normal operation of electronic components, further improving the operational reliability of the power converter.

It is important to note that the above is only some preferred embodiments of the present disclosure and the applied technical principle. Those skilled in the art should understand that the present disclosure is not limited to the specific embodiments described here. Those skilled in the art can make various significant changes, readjustments and replacements without deviating from the scope of protection of the present disclosure. Therefore, the present disclosure is described in detail through the above-mentioned embodiments, but is not limited to the above-mentioned embodiments. Other equivalent embodiments are possible without departing from the idea of the present disclosure, and the scope of the present disclosure is determined by the appended claims.

**Claims**

1. A power converter, comprises:

   a printed circuit board (1), the printed circuit board being provided with power devices and control devices;
   a connection member (2), one end of the connection member (2) being connected to an external wire harness of the power converter, and the other end being connected to the printed circuit board (1);
   a housing (32), a blocking wall (321) being arranged within the housing (32), the printed circuit board (1) being installed within the housing (32), the printed circuit board (1) abutting against the blocking wall (321), and the blocking wall (321) surrounding an outer side of the connection member (2) to isolate both the power device and the control device from the connection member (2).

2. The power converter according to claim 1, **characterized in that** a screw hole (3211) is disposed in the blocking wall (321), and a fixing hole is disposed in the printed circuit board (1), and a screw passes through the fixing hole and is connected to the screw hole (3211) by a thread to fix the printed circuit board (1) on top of the blocking wall (321); or

a welding pin is disposed on a top surface of the blocking wall (321), a welding hole is disposed in the printed circuit board (1), and the welding pin is able to pass through the welding hole and is connected to the welding hole by welding.

3. The power converter according to claim 1, **characterized in that** the material of both the blocking wall (321) and the housing (32) is metal, and the blocking wall (321) and the housing (32) are integrally formed.

4. The power converter according to claim 1, **characterized in that** the connection member (2) comprises:

a first contact (21), the first contact being provided with a first power terminal (211), a first end of the first power terminal (211) being connected to the external wire harness;
a second contact (22), the second contact being provided with a second power terminal (221), a second end of the first power terminal (211) being fixedly and electrically connected to the second power terminal (221), the first power terminal (211) being electrically connected to the printed circuit board (1) by means of the second power terminal (221);
wherein a welded connection is used between the first power terminal (211) and the second power terminal (221); or
a screw connection is used between the first power terminal (211) and the second power terminal (221).

5. The power converter according to claim 4, **characterized in that** a differential mode inductor terminal (2211) is disposed on the second power terminal (221), and a differential mode inductor is disposed on the printed circuit board (1), and the differential mode inductor terminal (2211) is electrically connected to the differential mode inductor.

6. The power converter according to claim 5, **characterized in that** the differential mode inductor terminal (2211) comprises a plurality of differential mode inductor sub-terminals, and the plurality of differential mode inductor sub-terminals are arranged within a circle with a diameter of not more than 17 mm; and the distance between any two of the plurality of differential mode inductor sub-terminals are not less than 3 mm.

7. The power converter according to claim 5, **characterized in that** the second contact (22) further comprises a magnetic ring (23), mounting positions are disposed on the second contact (22), and the magnetic ring (23) is installed within the mounting positions, and the magnetic ring (23) is arranged around an outer side of the differential mode inductor terminal (2211).

8. The power converter according to claim 7, **characterized in that** the mounting positions are mounting ribs, and the magnetic ring (23) is bonded to the mounting ribs by glue dispensing; or

the magnetic ring (23) is snapped into the mounting ribs; or
the number of mounting ribs is at least two, and the magnetic ring (23) is installed between the mounting ribs, and threaded holes are disposed in the mounting ribs, and bolts are connected to the threaded holes by threads such that end faces of the bolts abut against the magnetic ring (23).

9. The power converter according to claim 4, **characterized in that** a common mode capacitor terminal (2212) is disposed on the second power terminal (221), and a common mode capacitor is disposed on the printed circuit board (1), the common mode capacitor terminal (2212) is electrically connected to the common mode capacitor.

10. The power converter according to claim 4, **characterized in that** the first contact (21) is further provided with a signal terminal (212), and one end of the signal terminal (212) is connected to an external signal wire harness, and the other end is connected to the printed circuit board (1).

Fig. 1

Fig. 2

Fig. 3

Fig. 4

Fig. 5

Fig. 6

Fig. 7

Fig. 8

**INTERNATIONAL SEARCH REPORT**

| International application No. |
| --- |
| **PCT/CN2021/135530** |

**A. CLASSIFICATION OF SUBJECT MATTER**

H05K 9/00(2006.01)i; H05K 7/14(2006.01)i; H05K 7/10(2006.01)i; H02M 1/00(2007.01)n; H02M 1/44(2007.01)i

According to International Patent Classification (IPC) or to both national classification and IPC

**B. FIELDS SEARCHED**

Minimum documentation searched (classification system followed by classification symbols)

H05K

Documentation searched other than minimum documentation to the extent that such documents are included in the fields searched

Electronic data base consulted during the international search (name of data base and, where practicable, search terms used)

CNTXT, CNKI, DWPI, ENTXT, ENTXTC: 印刷电路板, 接插, 插接, 端子, 插头, 连接, 壳体, 屏蔽, 隔离, 差模, 电感, 共模, 电容, 信号, 功率, 磁环, 安装筋, 安装, PCB, connect, terminal, contact, shell, body, shield, capacitor, reduct+, induct+, difference mode, common mode, magnetic ring, power, signal, transformer, fix, hold.

**C. DOCUMENTS CONSIDERED TO BE RELEVANT**

| Category* | Citation of document, with indication, where appropriate, of the relevant passages | Relevant to claim No. |
| --- | --- | --- |
| PX | CN 112366924 A (SHANGHAI VALEO AUTOMOTIVE ELECTRICAL SYSTEMS CO., LTD.) 12 February 2021 (2021-02-12) claims 1-10 | 1-10 |
| PX | CN 112423568 A (SHANGHAI VALEO AUTOMOTIVE ELECTRICAL SYSTEMS CO., LTD.) 26 February 2021 (2021-02-26) description, paragraphs [0038]-[0068], and figures 1-8 | 1-10 |
| PX | CN 112423569 A (SHANGHAI VALEO AUTOMOTIVE ELECTRICAL SYSTEMS CO., LTD.) 26 February 2021 (2021-02-26) description, paragraphs [0038]-[0068], and figures 1-8 | 1-10 |
| PX | CN 213603033 U (SHANGHAI VALEO AUTOMOTIVE ELECTRICAL SYSTEMS CO., LTD.) 02 July 2021 (2021-07-02) description, paragraphs [0038]-[0068], and figures 1-8 | 1-10 |
| X | CN 109845427 A (HELLA KGAA HUECK & CO., LTD.) 04 June 2019 (2019-06-04) description, paragraphs [0024]-[0034], and figures 1-4 | 1-3 |
| Y | CN 109845427 A (HELLA KGAA HUECK & CO., LTD.) 04 June 2019 (2019-06-04) description, paragraphs [0024]-[0034], and figures 1-4 | 4-10 |

| ✓ Further documents are listed in the continuation of Box C. | ✓ See patent family annex. |
| --- | --- |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **22 February 2022** | **02 March 2022** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2021/135530**

**C.   DOCUMENTS CONSIDERED TO BE RELEVANT**

| Category* | Citation of document, with indication, where appropriate, of the relevant passages | Relevant to claim No. |
|---|---|---|
| Y | CN 210805459 U (SHENZHEN SOFARSOLAR CO., LTD.) 19 June 2020 (2020-06-19) description, paragraphs [0028]-[0037], and figures 1-4 | 4-10 |
| X | US 2010172115 A1 (HONEYWELL INTERNATIONAL INC.) 08 July 2010 (2010-07-08) description, paragraphs [0013]-[0041], and figures 1-7 | 1-3 |
| X | DE 4212369 A1 (SIEMENS AKTIENGESELLSCHAFT) 14 October 1993 (1993-10-14) description, column 1, line 46 - column 3, line 60, figures 1-3 | 1-3 |
| X | CN 111386022 A (BYD COMPANY LTD.) 07 July 2020 (2020-07-07) description, paragraphs [0034]-[0035], and figures 1-9 | 1-3 |
| A | CN 111386022 A (BYD COMPANY LTD.) 07 July 2020 (2020-07-07) entire document | 4-10 |
| A | CN 108880283 A (SHENZHEN RONGXIN TECHNOLOGY CO., LTD.) 23 November 2018 (2018-11-23) entire document | 4-10 |

Form PCT/ISA/210 (second sheet) (January 2015)

**INTERNATIONAL SEARCH REPORT**
Information on patent family members

International application No.

**PCT/CN2021/135530**

| Patent document cited in search report | | | Publication date (day/month/year) | Patent family member(s) | | | Publication date (day/month/year) |
|---|---|---|---|---|---|---|---|
| CN | 112366924 | A | 12 February 2021 | CN | 213602550 | U | 02 July 2021 |
| CN | 112423568 | A | 26 February 2021 | CN | 213603031 | U | 02 July 2021 |
| CN | 112423569 | A | 26 February 2021 | CN | 213603032 | U | 02 July 2021 |
| CN | 213603033 | U | 02 July 2021 | | None | | |
| CN | 109845427 | A | 04 June 2019 | DE | 102016119300 | A1 | 12 April 2018 |
| | | | | WO | 2018069156 | A1 | 19 April 2018 |
| | | | | CN | 109845427 | B | 24 November 2020 |
| CN | 210805459 | U | 19 June 2020 | | None | | |
| US | 2010172115 | A1 | 08 July 2010 | JP | 2010161365 | A | 22 July 2010 |
| | | | | EP | 2205050 | A2 | 07 July 2010 |
| | | | | EP | 2205050 | A3 | 15 October 2014 |
| | | | | IL | 202446 | D0 | 30 June 2010 |
| | | | | IL | 202446 | A | 28 November 2013 |
| | | | | US | 7939766 | B2 | 10 May 2011 |
| DE | 4212369 | A1 | 14 October 1993 | DE | 4212369 | C2 | 11 December 1997 |
| CN | 111386022 | A | 07 July 2020 | WO | 2020135732 | A1 | 02 July 2020 |
| | | | | CN | 209594201 | U | 05 November 2019 |
| CN | 108880283 | A | 23 November 2018 | | None | | |

Form PCT/ISA/210 (patent family annex) (January 2015)